# EUROPÄISCHE PATENTSCHRIFT

(11) **EP 2 223 336 B1**
(45) Veröffentlichungstag und Bekanntmachung des Hinweises auf die Patenterteilung: **20.07.2016**
(21) Anmeldenummer: 08865050.2
(22) Anmeldetag: 09.12.2008
(51) Int. Cl.: H01L 25/075, H01L 25/16, H01L 27/15, H01L 23/60

(54) **LEUCHTDIODENCHIP MIT ÜBERSPANNUNGSSCHUTZ**
LED CHIP WITH DISCHARGE PROTECTION
PUCE À DIODE ÉLECTROLUMINESCENTE AVEC PROTECTION CONTRE LES SURTENSIONS

(30) Priorität: 20.12.2007 DE 102007061479
(43) Veröffentlichungstag der Anmeldung: 01.09.2010
(73) Patentinhaber: OSRAM Opto Semiconductors GmbH, 93055 Regensburg (DE)
(72) Erfinder: SORG, Jörg Erich, 93053 Regensburg (DE); GRUBER, Stefan, 93077 Bad Abbach (DE); BOGNER, Georg, 93138 Lappersdorf (DE)
(74) Vertreter: Epping - Hermann - Fischer
(86) Internationale Anmeldenummer: PCT/DE2008/002058
(87) Internationale Veröffentlichungsnummer: WO 2009/079983

(56) Entgegenhaltungen:
- EP-A- 1 601 019
- WO-A-2007/122548
- US-A1- 2005 242 358
- US-A1- 2006 071 229

## Beschreibung

Optoelektronische Bauelemente können durch elektrostatische Entladung, abgekürzt ESD für den englischen Ausdruck electrostatic discharge, zerstört werden. Bei einem Leuchtdiodenchip können elektrische Wechselfelder beispielsweise auch schon beim Einbau in eine Leiterplatte oder in ein Gehäuse Schäden verursachen.

In der Druckschrift US 2006/0071229 A1 ist eine integrierte Diode in einem Chippackage angegeben.

Die Druckschrift EP 1 601 019 A2 betrifft eine Leuchtdiode mit integriertem Schutz vor elektrostatischer Entladung.

Eine Leuchtdiode ist in der Druckschrift US 2005/0242358 A1 offenbart.

In der Druckschrift WO 2007/122548 A2 ist eine thermische Isolation elektrischer Bauteile für Leuchtdioden beschrieben.

Eine zu lösende Aufgabe ist es, bei einem möglichst geringen zusätzlichen Platzbedarf einen Leuchtdiodenchip vor Überspannungen zu schützen.

Diese Aufgabe wird durch einen Leuchtdiodenchip mit den Merkmalen des Anspruchs 1 gelöst.

Es wird ein Leuchtdiodenchip angegeben, der eine Vorrichtung zum Schutz vor Überspannungen aufweist. Die Vorrichtung wird im Folgenden als ESD-Schutzvorrichtung bezeichnet.

Ein Leuchtdiodenchip umfasst eine Halbleiterschichtenfolge, die sich auf einem Träger befindet. In das Trägersubstrat ist mittels Dotierung bestimmter Bereiche des Substrats eine ESD-Schutzvorrichtung integriert.

In einer Ausführungsform handelt es sich bei dem Leuchtdiodenchip um einen Dünnfilm-Leuchtdiodenchip. Hier wird die Halbleiterschichtenfolge auf ein Substrat aufgewachsen, das beispielsweise Saphir enthält. Die Seite der Halbleiterschichtenfolge, die vom Aufwachssubstrat abgewandt ist, wird mit einem weiteren Trägersubstrat verbunden. Das Aufwachssubstrat kann dann vollständig oder teilweise entfernt werden.

Die Halbleiterschichtenfolge weist zur elektrischen Kontaktierung einen unteren und einen oberen Kontaktbereich auf. Einer oder auch beide der Kontaktbereiche können beispielsweise ein transparentes leitfähiges Oxid umfassen, das auch verkürzt als TCO-Material, für transparent conductive oxide, bezeichnet wird. In einer weiteren Ausführungsform umfasst mindestens einer der Kontaktbereiche ein Metall oder eine metallische Legierung. Geeignete Metalle sind z.B. Palladium, Platin, Nickel, Gold, Silber, Aluminium, Rhodium, Titan oder eine Legierung mit zumindest einem dieser Materialien.

Der untere Kontaktbereich ist vorzugsweise mittels eines elektrisch leitenden Materials, beispielsweise eines Lotes oder eines elektrisch leitfähigen Klebers auf dem Träger befestigt.

In einer bevorzugten Ausführungsform umfasst das Trägersubstrat Halbleitermaterialien wie Silizium, Siliziumkarbid, Galliumarsenid, Galliumnitrid oder Germanium. Der Teilbereich des Trägers, der außerhalb der ESD-Schutzvorrichtung liegt, ist elektrisch leitfähig. Dabei kann die Leitfähigkeit durch eine p- oder eine n-Dotierung erhöht sein. Zur elektrischen Kontaktierung befindet sich vorzugsweise eine elektrische Anschlussfläche auf einer der Halbleiterschichtenfolge abgewandten Seite des Trägers. Diese Anschlussfläche kann mit einer Leiterbahnstruktur einer Leiterplatte verbunden werden.

In einer nicht erfindungsgemäßen Abwandlung ist der Träger elektrisch isolierend und umfasst beispielsweise Materialien wie Aluminiumnitrid oder Saphir. In diesem Fall kann die elektrische Kontaktierung mittels Durchkontaktierungen durch den Träger erfolgen, die ein elektrisch leitfähiges Material aufweisen.

Der obere Kontaktbereich der Halbleiterschichtenfolge wird beispielsweise mittels eines Bonddrahtes elektrisch kontaktiert. Dazu wird auf einen Teilbereich des oberen Kontaktbereichs eine metallisierte Schicht, das so genannte Bondpad aufgebracht. Das Bondpad enthält bevorzugt ein Metall oder eine metallische Legierung, besonders bevorzugt Gold.

An das Bondpad wird ein elektrisch leitendes Verbindungsmaterial befestigt. Beispielsweise wird ein Bonddraht aufgelötet, der an seinem anderen Ende mit einem Anschlussbereich auf einer Leiterplatte elektrisch verbunden werden kann.

Die ESD-Schutzvorrichtung ist in dem Träger integriert, indem bestimmte Teilbereiche des Trägersubstrats spezifisch dotiert werden.

Eine derartige ESD-Schutzvorrichtung schützt den Leuchtdiodenchip vor elektrischen Überspannungen, schon bevor er an mögliche weitere Bauelemente, wie zum Beispiel eine Leiterplatte, angeschlossen wird, oder in ein Gehäuse eingebaut wird.

Diese Teilbereiche sind vom restlichen Trägersubstrat mittels einer Barriereschicht elektrisch isoliert. Zur Herstellung der Barriereschicht wird beispielsweise ein Graben in das Substrat geätzt, der anschließend mit einem isolierenden Material wie Siliziumnitrid oder Siliziumdioxid aufgefüllt wird.

In einer Ausführungsform ist der ESD-Schutz als Diode ausgebildet.

Hierzu wird ein erster Bereich des Trägersubstrats n-dotiert, ein daran angrenzender zweiter Bereich p-dotiert. Wird diese Diode mit der Halbleiterschichtenfolge antiparallel verschaltet, so ist der Leuchtdiodenchip mindestens in Rückwärtsrichtung vor Überspannungen geschützt.

In einer bevorzugten Ausführungsform wird die Dotierung des Trägersubstrats so vorgenommen, dass eine Diode mit der Kennlinie einer Zener-Diode entsteht. Eine derartige zener-Diode weist in Vorwärtsrichtung eine Kennlinie auf, die der einer normalen Diode entspricht. In Rückwärtsrichtung jedoch wird die Zener-Diode ab einer bestimmten Spannung niederohmig. Dadurch ist das elektronische Bauelement bei einer antiparallelen Verschaltung mit einer Zener-Diode sowohl in Vorwärtsals auch in Rückwärtsrichtung vor Überspannungen geschützt.

In weiteren Ausführungsformen kann die ESD-Schutzvorrichtung die Kennlinie anderer elektronischer Bauelemente aufweisen.

Es ist die ESD-Schutzvorrichtung mittels einer elektrischen Leiterstruktur mit der Halbleiterschichtenfolge verbunden.

Besonders vorteilhaft sind dabei die Bereiche der ESD-Schutzvorrichtung und der Halbleiterschichtenfolge miteinander antiparallel verschaltet, die jeweils vom Träger abgewandt sind. Die Leiterstruktur ist beispielsweise mit dem oberen Kontaktbereich der Halbleiterschichtenfolge verbunden.

Die Leiterstruktur wird bevorzugt mittels Sputtern, Aufdampfen oder galvanischer Abscheidung erzeugt. Beispielsweise kann die elektrische Leiterstruktur aus einem Metall bestehen oder teilweise ein Metall aufweisen. Alternativ dazu kann auch ein TCO-Material oder eine transparente elektrisch leitfähige Kunststoffschicht verwendet werden. Derartige Materialien werden vorzugsweise durch Aufdampfen, Aufdrucken, Aufsprühen oder Aufschleudern aufgebracht.

Es ist die elektrische Leiterstruktur teilweise oder vollständig von einer Isolierschicht umschlossen.

Diese Schicht befindet sich mindestens zwischen der Leiterstruktur und derjenigen Schicht der Halbleiterschichtenfolge, die nicht an den oberen Kontaktbereich der Halbleiterschichtenfolge angrenzt. So kann ein möglicher Kurzschluss dieser Bauelemente verhindert werden. Die Isolierschicht umfasst beispielsweise Siliziumnitrid.

In einer bevorzugten Ausführungsform sind die Halbleiterschichtenfolge und das Substrat mit der elektrischen Isolierschicht verkapselt.

Dadurch kann das elektronische Bauelement vor chemischen und mechanischen Einflüssen geschützt werden. Geeignete Materialien für eine derartige Isolierschicht sind beispielsweise Glas, Kunststoff oder Silikon. Das jeweilige Material kann zum Beispiel als vorgefertigte Schicht oder durch Aufdrucken, Aufsprühen oder Aufschleudern aufgebracht werden.

Die elektrische Leiterstruktur befindet sich auf dieser elektrischen Isolierschicht oder wird zusätzlich von dieser umschlossen.

Zur elektrischen Kontaktierung der Halbleiterschichtenfolge und der ESD-Schutzvorrichtung sind in die Isolierschicht Ausnehmungen eingebracht. Die Leiterstruktur ist durch diese Ausnehmungen hindurch mit den Anschlussbereichen der ESD-Schutzvorrichtung beziehungsweise der Halbleiterschichtenfolge verbunden. Dies gilt analog auch für weitere elektrische Anschlüsse, wie zum Beispiel bei der elektrischen Kontaktierung des Bondpads mittels eines Bonddrahts.

Die Ausnehmungen in der Isolierschicht werden vorzugsweise mittels einer Laserbearbeitung eingebracht. Zur Herstellung der Leiterstruktur wird beispielsweise mittels eines PVD-Verfahrens, wie zum Beispiel Sputtern, eine Metallschicht auf die Isolierschicht aufgebracht. Diese Metallschicht kann mittels galvanischer Abscheidung verstärkt werden.

Alternativ kann die Leiterstruktur auch unter Verwendung eines Druckverfahrens, insbesondere eines Siebdruckverfahrens, aufgebracht werden. Ferner kann das elektrisch leitfähige Material auch unter Verwendung eines Aufsprühverfahrens oder eines Aufschleuderverfahrens erzeugt werden.

Nach dem Ausbilden einer elektrischen Leiterstruktur kann diese zusätzlich mit einer elektrisch isolierenden Deckschicht bedeckt werden. Die isolierende Deckschicht ist vorzugsweise eine Kunststoffschicht, zum Beispiel eine Lackschicht.

Es weist die ESD-Schutzvorrichtung, in einer Richtung parallel zu einer Wachstumsrichtung der Halbleiterschichtenfolge, genau einen n-dotierten und genau einen p-dotierten Teilbereich auf. Weiterhin sind diese dotierten Teilbereiche, in einer Richtung parallel zur Wachstumsrichtung der Halbleiterschichtenfolge, insbesondere deckungsgleich angeordnet. Mit anderen Worten können die p- und n-dotierten Teilbereiche genau übereinander liegen.

Es sind die dotierten Teilbereiche der ESD-Schutzvorrichtung durch die Barriereschicht von restlichen Teilbereichen des Trägers abgetrennt. Mit anderen Worten liegt kein direkter Kontakt zwischen einem Material des wenigstens einen dotierten Teilbereichs und einem Material des restlichen Teilbereichs des Trägers vor.

Es sind die dotierten Teilbereiche der ESD-Schutzvorrichtung durch die Barriereschicht vom restlichen Teilbereich des Trägers vollständig abgetrennt und stehen nicht in direktem elektrischen Kontakt mit dem restlichen Teilbereich des Trägers. Vollständig abgetrennt bedeutet, dass kein direkter Kontakt zwischen dem Material der dotierten Teilbereiche und dem Material des restlichen Teilbereichs des Trägers besteht. Dass kein direkter elektrischer Kontakt vorliegt, bedeutet, dass zwischen den dotierten Teilbereichen und dem restlichen Teilbereich des Trägers kein unmittelbarer Stromfluss erfolgt. Ein Stromfluss etwa von den dotierten Teilbereichen zu dem restlichen Teilbereich des Trägers erfolgt also zum Beispiel indirekt über die Halbleiterschichtenfolge oder über eine Anschlussfläche, die sich an der der Halbleiterschichtenfolge abgewandten Seite des Trägers befindet.

Gemäß zumindest einer nicht erfindungsgemäßen Abwandlung des Leuchtdiodenchips erstreckt sich die Barriereschicht, in einer Richtung parallel zur Wachstumsrichtung der Halbleiterschichtenfolge, zu mindestens 20 % und zu höchstens 80 % in die Halbleiterschichtenfolge hinein, insbesondere von der der Halbleiterschichtenfolge zugewandten Seite des Trägers aus gesehen.

Gemäß zumindest einer Ausführungsform des Leuchtdiodenchips ist eine Haupterstreckungsrichtung der Barriereschicht parallel zur Wachstumsrichtung der Halbleiterschichtenfolge orientiert.

Es ist die Barriereschicht durch den Graben gebildet. Dieser Graben ist zum Beispiel über tief-reaktives Ionenätzen erzeugt.

Es ist der Graben mit einem dielektrischen Feststoff, insbesondere mit Siliziumoxid oder Siliziumnitrid, gefüllt. Alternativ und nicht erfindungsgemäß ist der Graben mit einem Gas, insbesondere mit Luft, gefüllt.

Gemäß zumindest einer Ausführungsform des Leuchtdiodenchips ist der Graben durch tief-reaktives Ionenätzen erzeugt und weist strukturierte Wände auf. Solche strukturierten Wände ermöglichen zum Beispiel eine bessere Haftung eines Materials, das in den Graben gefüllt ist. Bei dem Material kann es sich etwa um Siliziumoxid oder Siliziumnitrid handeln.

In einer Abwandlung des Leuchtdiodenchips ist die Barriereschicht durch einen pn-Übergang gebildet. Insbesondere weist dieser pn-Übergang eine Raumladungszone auf, die an einer Grenzfläche zwischen dem zum Beispiel p-dotierten Teilbereich der ESD-Schutzvorrichtung und dem restlichen, zum Beispiel n-dotierten Teilbereich des Trägers auftritt.

Im Folgenden werden der angegebene Halbleiterchip und vorteilhafte Ausgestaltungen anhand von schematischen und nicht maßstabsgetreuen Figuren erläutert. Es zeigen:
- Figur 1: Schnittbild eines Ausführungsbeispiels eines Halbleiterchips mit einer im Träger integrierten Z-Diode,
- Figur 2: Aufsicht auf den Halbleiterchip gemäß Figur 1,
- Figur 3: Schnittbild einer Abwandlung eines Halbleiterchips mit einer Barriereschicht, die den Träger nicht vollständig durchdringt,
- Figur 4: Schnittbild einer Abwandlung eines Halbleiterchips, bei dem die Barriereschicht durch einen pn-Übergang gebildet ist, und
- Figur 5: Schema eines Herstellungsprozesses einer als Graben gestalteten Barriereschicht eines Ausführungsbeispiels eines Halbleiterchips.

Gleiche, gleichartige und gleich wirkende Elemente sind in den Figuren mit gleichen Bezugszeichen versehen.

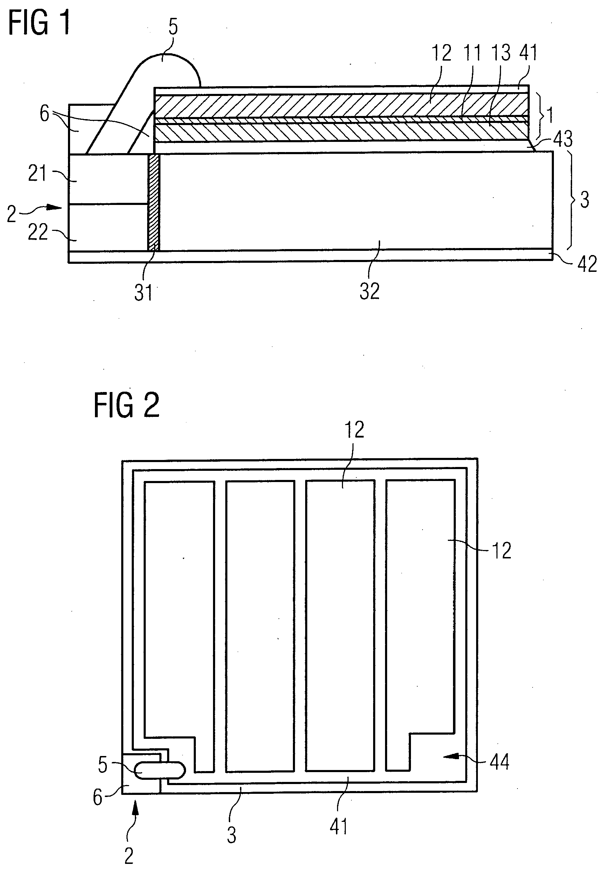

Figur 1 zeigt eine Ausführungsform des Leuchtdiodenchips mit einer ESD-Schutzvorrichtung 2. Eine Halbleiterschichtenfolge 1, die eine aktive Schicht 11 zur Erzeugung elektromagnetischer Strahlung umfasst, ist auf einem Träger 3 angeordnet. Beispielsweise ist die Schicht 12 der Halbleiterschichtenfolge 1 n-dotiert und die weitere Schicht 13 p-dotiert.

Vorzugsweise ist der Leuchtdiodenchip ein Dünnfilm-Leuchtdiodenchip, bei dem ein Aufwachssubstrat für die Halbleiterschichtenfolge 1 vollständig oder teilweise entfernt wurde. Insbesondere ist der Träger 3 vom Aufwachssubstrat verschieden.

In den Träger 3 ist eine ESD-Schutzvorrichtung 2 integriert, die mittels Dotierungen zweier Teilbereiche 21, 22 des Trägers 3 erzeugt wurde. Diese ESD-Schutzvorrichtung 2 ist hier als Zener-Diode ausgeführt, wobei der erste Bereich 21 der ESD-Schutzvorrichtung 2 p-dotiert und der zweite Bereich 22 n-dotiert ist.

Eine elektrische Leiterstruktur 5 verbindet die ESD-Schutzvorrichtung 2 mit dem oberen Kontaktbereich 41 der Halbleiterschichtenfolge 1. Bei der so verwirklichten antiparallelen Verschaltung der Bauelemente ist der Leuchtdiodenchip sowohl in Vorwärts- als auch in Rückwärtsrichtung vor Überspannungen geschützt.

Die elektrische Leiterstruktur 5 umfasst beispielsweise ein Metall, ein TCO-Material oder Kunststoff.

Die elektrische Leiterstruktur 5 ist teilweise von einer Isolierschicht 6 bedeckt, die Siliziumnitrid umfassen kann. Diese Schicht 6 befindet sich mindestens zwischen der Leiterstruktur 5 und derjenigen Schicht 13 der Halbleiterschichtenfolge, die nicht an den oberen Kontaktbereich 41 angrenzt. Dadurch kann ein möglicher Kurzschluss dieser Bauelemente verhindert werden.

In einer bevorzugten Ausführungsform sind die Halbleiterschichtenfolge 1 und das Substrat 3 mit der elektrischen Isolierschicht verkapselt. Die elektrische Leiterstruktur 5 befindet sich auf dieser Isolierschicht oder wird von dieser umschlossen.

Die ESD-Schutzvorrichtung 2 wird vom restlichen Trägersubstrat 32 durch eine Barriereschicht 31 elektrisch isoliert beziehungsweise vollständig abgetrennt, so dass ein Material der Teilbereiche 21, 22 nicht in direktem elektrischen Kontakt zum restlichen Teilbereich 32 des Trägers 3 steht. Zur Herstellung der Barriereschicht 31 wird beispielsweise in das Substrat 3 ein Graben geätzt, der anschließend mit Siliziumnitrid oder Siliziumdioxid aufgefüllt wird. Der Graben durchdringt den Träger 3, in einer Richtung parallel zu einer Wachstumsrichtung der Halbleiterschichtenfolge 1, vollständig.

Die Halbleiterschichtenfolge 1 weist zur elektrischen Kontaktierung einen unteren 43 und einen oberen 41 Kontaktbereich auf. Einer oder auch beide der Kontaktbereiche können beispielsweise ein transparentes leitfähiges Oxid umfassen. In einer Ausführungsform umfasst mindestens einer der Kontaktbereiche ein Metall oder eine metallische Legierung. Geeignete Metalle sind zum Beispiel Palladium, Platin, Nickel, Gold, Silber, Aluminium, Rhodium, Titan oder eine Legierung mit zumindest einem dieser Materialien.

Der untere Kontaktbereich 43 ist vorzugsweise mittels eines elektrisch leitenden Materials, beispielsweise eines Lotes oder eines elektrisch leitfähigen Klebers auf dem Trägersubstrat 3 befestigt.

Der Träger 3 umfasst in einer bevorzugten Ausführungsform Halbleitermaterialien wie Silizium, Siliziumkarbid, Galliumarsenid, Galliumnitrid oder Germanium. Der Teilbereich 32 des Trägers 3, der außerhalb der ESD-Schutzvorrichtung 2 liegt, ist elektrisch leitfähig. Dabei kann die Leitfähigkeit durch eine p- oder eine n-Dotierung erhöht sein. Zur elektrischen Kontaktierung weist der Träger 3 auf einer der Halbleiterschichtenfolge 1 abgewandten Seite eine elektrische Anschlussfläche 42 auf. Diese Anschlussfläche 42 kann mit einer Leiterbahnstruktur einer Leiterplatte verbunden werden.

Figur 2 zeigt eine Aufsicht auf den Halbleiterchip gemäß Figur 1. Die dem Träger 3 abgewandte Schicht 12 der Halbleiterschichtenfolge 1 belegt einen Großteil des dargestellten Bereichs. Weiterhin sind der obere elektrische Kontaktbereich 41 und die elektrische Anschlussfläche 44 zu sehen. Diese Anschlussfläche 44 kann hier als metallisierte Schicht, ein so genanntes Bondpad, ausgeführt sein, das beispielsweise Gold umfasst. An diese Anschlussfläche 44 kann eine elektrisch leitfähige Verbindung, beispielsweise ein Bonddraht aufgelötet werden, der an seinem anderen Ende mit einem weiteren Anschlussbereich auf einer Leiterplatte elektrisch verbunden werden kann.

Der Träger 3 ist in den Randbereichen der Darstellung nicht von der Halbleiterschichtenfolge 1 bedeckt und so in der Aufsicht zu erkennen. In der unteren linken Ecke der Aufsicht weist die Halbleiterschichtenfolge 1 eine Aussparung auf. Hier befindet sich die ESD-Schutzvorrichtung 2, die von der Isolierschicht 6 bedeckt ist. Die elektrische Leiterstruktur 5 verbindet die ESD-Schutzvorrichtung 2 durch die Isolierschicht 6 hindurch mit dem oberen Kontaktbereich 41 der Halbleiterschichtenfolge 1.

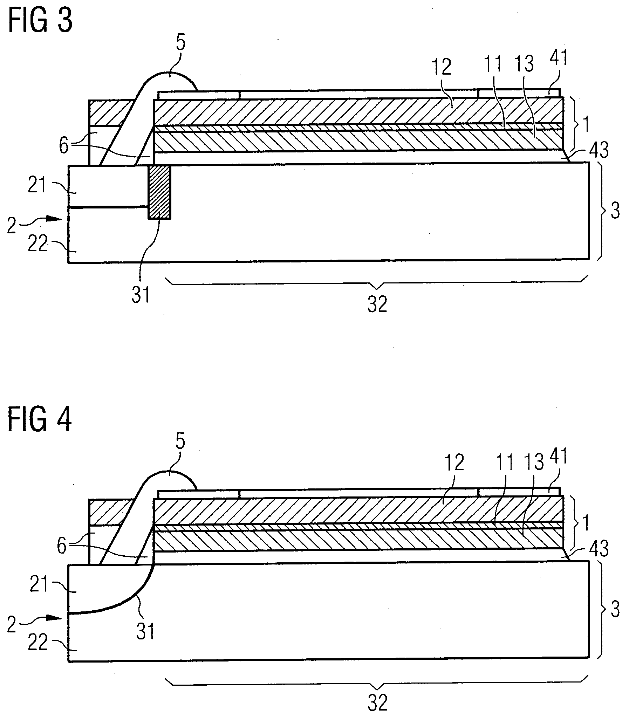

Figur 3 zeigt eine nicht erfindungsgemäße Abwandlung des Leuchtdiodenchips analog zu Figur 1. Der Träger 3 ist hierbei n-dotiert. Die Barriereschicht 31 reicht, von einer der Halbleiterschichtenfolge 1 zugewandten Seite des Trägers 3 aus gesehen, zu zirka 50 % in den Träger 3 hinein. Die Barriereschicht 31 ist durch einen Graben gebildet, der mit Siliziumnitrid oder mit Luft gefüllt ist. Der p-dotierte Teilbereich 21 der ESD-Schutzvorrichtung 2 ist durch die Barriereschicht 31 vom restlichen Teilbereich 32 des Trägers 3 separiert, das heißt, die Materialien der Teilbereiche 21, 32 stehen nicht in direktem Kontakt miteinander. Des Weiteren befinden sich die Teilbereiche 21, 22 der ESD-Schutzvorrichtung 2, in einer Richtung parallel zu der Wachstumsrichtung der Halbleiterschichtenfolge 1, übereinander.

Bei der Abwandlung gemäß Figur 4 ist die Barriereschicht 31 durch einen pn-Übergang zwischen dem p-dotierten Teilbereich 21 und dem n-dotierten Teilbereich 22 der ESD-Schutzvorrichtung 2 sowie dem restlichen Teilbereich 32 des Trägers 3 gebildet. Die dem Träger 3 zugewandte Schicht 13 der Halbleiterschichtenfolge 1 ist in diesem Falle bevorzugt p-dotiert, die dem Träger 3 abgewandte Schicht 12 der Halbleiterschichtenfolge ist bevorzugt n-dotiert.

Im normalen Betrieb des Leuchtdiodenchips liegt am Träger 3 zum Beispiel eine positive Spannung und am oberen Kontaktbereich 41 eine negative Spannung an. Es erfolgt also ein Stromfluss über den oberen Kontaktbereich 41, über die n-dotierte Schicht 12, über die aktive Schicht 11, über die p-dotierte Schicht 13 und über den unteren Kontaktbereich 43 sowie gegebenenfalls über den Träger 3. Da der p-dotierte Teilbereich 21 mit dem als Kathode geschalteten oberen Kontaktbereich 41 in Verbindung steht, erfolgt im normalen Betrieb des Leuchtdiodenchips kein Stromfluss vom p-dotierten Teilbereich 21 zum n-dotierten Teilbereich 22.

Ist der Leuchtdiodenchip nicht im Betrieb, so dass keine definierte, externe Spannung angelegt ist, so kann bei Auftreten einer Spannung in Sperrrichtung der Halbleiterschichtenfolge 1 im ESD-Fall dann ein Strom über die dotierten Teilbereiche 21, 22 abfließen, so dass eine Zerstörung des Leuchtdiodenchips vermieden ist.

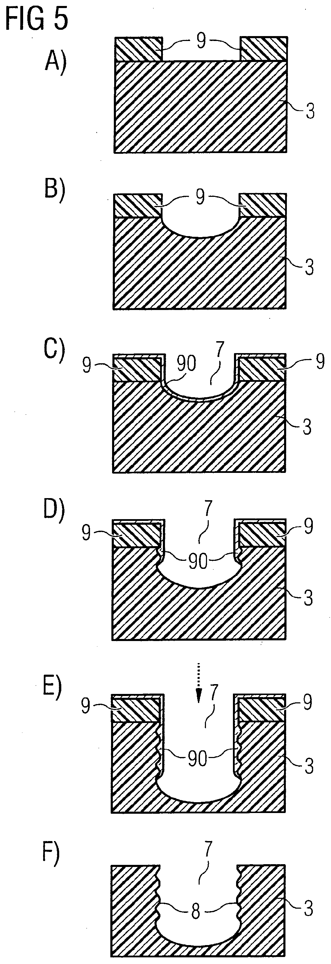

Ein Herstellungsverfahren für die Barriereschicht 31 ist in Figur 5 schematisch illustriert. Gemäß Figur 5A ist auf dem Träger 3 strukturiert ein Fotolack 9 aufgebracht. Bereiche, in denen die Barriereschicht 31 gebildet werden soll, sind vom Fotolack 9 unbedeckt.

Gemäß Figur 5B erfolgt ein Ätzen über tief-reaktives Ionenätzen, so dass in vom Fotolack unbedeckten Bereichen Material des Trägers 3 abgetragen wird und ein Graben 7 resultiert. Der Graben 7 weist allerdings nur eine geringe Tiefe auf.

In einem nächsten Prozessschritt, illustriert in Figur 5C, wird über dem Fotolack 9 sowie über dem Graben 7 eine Passivierung 90 aufgebracht.

Wie in Figur 5D zu sehen ist, wird die Passivierung 90 in zu ätzenden Bereichen entfernt, so dass im nachfolgenden Ätzschritt der Graben 7 vertieft wird.

Die Verfahrensschritte gemäß den Figuren 5C und 5D werden so oft wiederholt, bis eine gewünschte Tiefe des Grabens 7 erreicht ist, vergleiche Figur 5E.

Abschließend werden Passivierung 90 und Fotolack 9 entfernt, sodass der Träger 3 und der Graben 7 mit der gewünschten Tiefe frei liegen. Aufgrund des iterativen Ätzens des Grabens 7 weisen Wände 8 des Grabens 7 eine Strukturierung auf. Diese Strukturierung ermöglicht beispielsweise in einem optionalen, weiteren Verfahrensschritt, bei dem ein Material in den Graben 7 eingebracht wird, eine bessere Haftung dieses Materials an den Wänden 8 und somit im Graben 7.

## Patentansprüche

1. Leuchtdiodenchip mit einer Halbleiterschichtenfolge (1), die sich auf einem Träger (3) befindet, und mit einer ESD-Schutzvorrichtung (2), die den Leuchtdiodenchip vor Überspannungen schützt,
wobei die ESD-Schutzvorrichtung (2) durch die Dotierung bestimmter Teilbereiche (21, 22) des Trägers (3) erzeugt ist und die ESD-Schutzvorrichtung (2), in einer Richtung parallel zu einer Wachstumsrichtung der Halbleiterschichtenfolge (1), genau einen n-dotierten (22) und genau einen p-dotierten Teilbereich (21) aufweist,
**dadurch gekennzeichnet, dass**
- die dotierten Teilbereiche (21, 22) der ESD-Schutzvorrichtung (2) durch eine Barriereschicht (31) von einem restlichen Teilbereich (32) des Trägers (3) vollständig abgetrennt sind und nicht in direktem elektrischen Kontakt mit diesem stehen,
- die ESD-Schutzvorrichtung (2) mittels einer elektrischen Leiterstruktur (5) mit der Halbleiterschichtenfolge (1) verbunden und die Halbleiterschichtenfolge (1) zumindest teilweise von einer Isolierschicht (6), auf der sich die elektrische Leiterstruktur (5) befindet, bedeckt ist,
- die Barriereschicht (31) durch einen mit Siliziumoxid oder Siliziumnitrid gefüllten Graben (7) gebildet ist,
- die Barriereschicht (31), in eine Richtung parallel zur Wachstumsrichtung, den Träger (3) vollständig durchdringt,
- der Träger (3) in einem umlaufenden Randbereich nicht von der Halbleiterschichtenfolge (1) bedeckt ist,
- die Halbleiterschichtenfolge (1), in Draufsicht gesehen, in einem Eckbereich eine Aussparung aufweist, in der sich die ESD-Schutzvorrichtung (2), die nicht von der Halbleiterschichtenfolge (1) überdeckt ist, befindet,
- der restliche Teilbereich (32) des Trägers (3), der außerhalb der ESD-Schutzvorrichtung (2) liegt, elektrisch leitfähig ist, und
- die Halbleiterschichtenfolge (1) zur elektrischen Kontaktierung einen unteren und einen oberen Kontaktbereich aufweist, wobei der obere Kontaktbereich dem Träger (3) abgewandt ist und der untere Kontaktbereich mittels eines elektrisch leitenden Materials auf dem Träger (3) befestigt ist.

2. Leuchtdiodenchip nach Anspruch 1,
- bei dem die ESD-Schutzvorrichtung (2) als Diode ausgebildet ist.

3. Leuchtdiodenchip nach Anspruch 2,
- bei dem die ESD-Schutzvorrichtung (2) als Zener-Diode ausgebildet ist.

4. Leuchtdiodenchip nach einem der Ansprüche 1 bis 3,
- bei dem die ESD-Schutzvorrichtung (2) von der Isolierschicht (6) bedeckt ist.

5. Leuchtdiodenchip nach einem der Ansprüche 1 bis 4,
- bei dem die elektrische Leiterstruktur (5) mindestens teilweise von der Isolierschicht (6) bedeckt ist.

6. Leuchtdiodenchip nach einem der Ansprüche 1 bis 5,
- bei dem der Träger (3) zumindest teilweise von der Isolierschicht (6) bedeckt ist.

7. Leuchtdiodenchip nach einem der Ansprüche 1 bis 6,
- bei dem die elektrische Leiterstruktur (5) durch Sputtern, Aufdampfen oder galvanische Abscheidung erzeugt ist.

8. Leuchtdiodenchip nach zumindest Anspruch 6,
- bei dem die Halbleiterschichtenfolge (1) und der Träger (3) von der Isolierschicht (6) verkapselt sind und die elektrische Leiterstruktur (5) von der Isolierschicht (6) umschlossen ist.

9. Leuchtdiodenchip nach einem der vorhergehenden Ansprüche,
- bei dem der Graben (7) durch tief-reaktives Ionenätzen erzeugt ist und strukturierte Wände (8) aufweist.

10. Leuchtdiodenchip nach einem der vorhergehenden Ansprüche,
- der an einer der Halbleiterschichtenfolge (1) abgewandten Seite des Trägers (3) eine erste elektrische Anschlussfläche (42) zur Verbindung mit einer Leiterplatte und an einer dem Träger (3) abgewandten Seite der Halbleiterschichtenfolge (1) eine zweite elektrische Anschlussfläche (44) zur Verbindung mit einem Bonddraht aufweist.

## Claims

1. Light emitting diode chip comprising a semiconductor layer sequence (1) situated on a carrier (3), and comprising an ESD protection device (2), which protects the light emitting diode chip against overvoltages, wherein the ESD protection device (2) is produced by the doping of specific partial regions (21, 22) of the carrier (3) and the ESD protection device (2) has, in a direction parallel to a growth direction of the semiconductor layer sequence (1), exactly one n-doped partial region (22) and exactly one p-doped partial region (21), **characterized in that**
- the doped partial regions (21, 22) of the ESD protection device (2) are completely separated by a barrier layer (31) from a remaining partial region (32) of the carrier (3) and are not in direct electrical contact with the latter,
- the ESD protection device (2) is connected to the semiconductor layer sequence (1) by means of an electrical conductor structure (5) and the semiconductor layer sequence (1) is covered at least partly by an insulation layer (6), on which the electrical conductor structure (5) is situated,
- the barrier layer (31) is formed by a trench (7) filled with silicon oxide or silicon nitride,
- the barrier layer (31), in a direction parallel to the growth direction, penetrates through the carrier (3) completely,
- the carrier (3) is not covered by the semiconductor layer sequence (1) in a circumferential marginal region,
- the semiconductor layer sequence (1), as seen in plan view, has a cutout in a corner region, the ESD protection device (2) which is not covered by the semiconductor layer sequence (1) being situated in said cutout,
- the remaining partial region (32) of the carrier (3) which lies outside the ESD protection device (2) is electrically conductive, and
- the semiconductor layer sequence (1) has a lower and an upper contact region for the purpose of electrical contacting, wherein the upper contact region faces away from the carrier (3) and the lower contact region is fixed on the carrier (3) by means of an electrically conductive material.

2. Light emitting diode chip according to Claim 1,
- wherein the ESD protection device (2) is embodied as a diode.

3. Light emitting diode chip according to Claim 2,
- wherein the ESD protection device (2) is embodied as a zener diode.

4. Light emitting diode chip according to any of Claims 1 to 3,
- wherein the ESD protection device (2) is covered by the insulation layer (6).

5. Light emitting diode chip according to Claims 1 to 4,
- wherein the electrical conductor structure (5) is covered at least partly by the insulation layer (6).

6. Light emitting diode chip according to any of Claims 1 to 5,
- wherein the carrier (3) is covered at least partly by the insulation layer (6).

7. Light emitting diode chip according to any of Claims 1 to 6,
- wherein the electrical conductor structure (5) is produced by sputtering, vapor deposition or electrodeposition.

8. Light emitting diode chip according to at least Claim 6,
- wherein the semiconductor layer sequence (1) and the carrier (3) are encapsulated by the insulation layer (6) and the electrical conductor structure (5) is enclosed by the insulation layer (6).

9. Light emitting diode chip according to any of the preceding claims,
- wherein the trench (7) is produced by deep reactive ion etching and has patterned walls (8).

10. Light emitting diode chip according to any of the preceding claims,
- which has, at a side of the carrier (3) facing away from the semiconductor layer sequence (1), a first electrical connection pad (42) for connection to a printed circuit board and, at a side of the semiconductor layer sequence (1) facing away from the carrier (3), a second electrical connection pad (44) for connection to a bonding wire.

## Revendications

1. Puce de diode électroluminescente comprenant une séquence de couches en semiconducteur (1) qui se trouvent sur un support (3), et comprenant un dispositif de protection contre les décharges électrostatiques (ESD) (2) qui protège la puce de diode électroluminescente contre les surtensions,
le dispositif de protection ESD (2) étant produit par le dopage de certaines zones partielles (21, 22) du support (3) et le dispositif de protection ESD (2) possédant, dans une direction parallèle à un sens de croissance de la séquence de couches en semiconducteur (1), exactement une zone partielle dopée n (22) et exactement une zone partielle dopée p (21),
**caractérisée en ce que**
- les zones partielles dopées (21, 22) du dispositif de protection ESD (2) sont totalement séparées d'une zone partielle restante (32) du support (3) par une couche de barrière (31) et ne se trouvent pas en contact électrique direct avec celle-ci,
- le dispositif de protection ESD (2) est relié à la séquence de couches en semiconducteur (1) au moyen d'une structure conductrice électrique (5) et la séquence de couches en semiconducteur (1) est au moins partiellement recouverte par une couche isolante (6) sur laquelle se trouve la structure conductrice électrique (5),
- la couche de barrière (31) est formée par une tranchée (7) remplie d'oxyde de silicium ou de nitrure de silicium,
- la couche de barrière (31) traverse entièrement le support (3) dans une direction parallèle au sens de croissance,
- le support (3) n'est pas recouvert par la séquence de couches en semiconducteur (1) dans une zone de bordure circonférentielle,
- la séquence de couches en semiconducteur (1), vue de dessus, possède dans une zone de coin une cavité dans laquelle se trouve le dispositif de protection ESD (2) qui n'est pas recouvert par la séquence de couches en semiconducteur (1),
- la zone partielle restante (32) du support (3), qui se trouve en-dehors du dispositif de protection ESD (2), est électriquement conductrice, et
- la séquence de couches en semiconducteur (1) possède une zone de contact inférieure et une zone de contact supérieure pour l'établissement du contact électrique, la zone de contact supérieure étant à l'opposé du support (3) et la zone de contact inférieure étant fixée sur le support (3) au moyen d'un matériau électriquement conducteur.

2. Puce de diode électroluminescente selon la revendication 1, pour laquelle le dispositif de protection ESD (2) est réalisé sous la forme d'une diode.

3. Puce de diode électroluminescente selon la revendication 2, pour laquelle le dispositif de protection ESD (2) est réalisé sous la forme d'une diode zener.

4. Puce de diode électroluminescente selon l'une des revendications 1 à 3, pour laquelle le dispositif de protection ESD (2) est recouvert par la couche isolante (6).

5. Puce de diode électroluminescente selon l'une des revendications 1 à 4, pour laquelle la structure conductrice électrique (5) est recouverte au moins partiellement par la couche isolante (6).

6. Puce de diode électroluminescente selon l'une des revendications 1 à 5, pour laquelle le support (3) est recouvert au moins partiellement par la couche isolante (6).

7. Puce de diode électroluminescente selon l'une des revendications 1 à 6, pour laquelle la structure conductrice électrique (5) est produite par pulvérisation cathodique, vaporisation ou précipitation galvanique.

8. Puce de diode électroluminescente selon la revendication 6, pour laquelle la séquence de couches en semiconducteur (1) et le support (3) sont encapsulés par la couche isolante (6) et la structure conductrice électrique (5) est entourée par la couche isolante (6).

9. Puce de diode électroluminescente selon l'une des revendications précédentes, pour laquelle la tranchée (7) est produite par gravure ionique réactive profonde et possède des parois structurées (8).

10. Puce de diode électroluminescente selon l'une des revendications précédentes, laquelle possède sur un côté du support (3), à l'opposé de la séquence de couches en semiconducteur (1), une première surface de raccordement (42) électrique servant à la liaison avec un circuit imprimé et sur un côté de la séquence de couches en semiconducteur (1), à l'opposé du support (3), une deuxième surface de raccordement (44) électrique servant à la liaison avec un fil de connexion.
